# EUROPEAN PATENT APPLICATION

(11) **EP 4 187 621 A1**
(43) Date of publication of application: **31.05.2023**
(21) Application number: 22206027.9
(22) Date of filing: 08.11.2022
(51) Int. Cl.: H01L 29/872, H01L 29/06, H01L 29/16, H01L 21/329, H01L 29/40, H01L 23/31

(54) **SIC-BASED ELECTRONIC DEVICE WITH ENHANCED ROBUSTNESS, AND METHOD FOR MANUFACTURING THE ELECTRONIC DEVICE**

(30) Priority: 26.11.2021 IT 202100029969
(71) Applicant: STMicroelectronics S.r.l., 20864 Agrate Brianza (MB) (IT)
(72) Inventor: RASCUNA', Simone, 95129 CATANIA (IT); PUGLISI, Valeria, 95125 CATANIA (IT); BELLOCCHI, Gabriele, 95124 CATANIA (IT)
(74) Representative: Studio Torta S.p.A.

(57) **Abstract**

An electronic device (50; 100) comprising: a semiconductor body (53) of silicon carbide; a first insulating layer (61) on a first surface (53a) of the semiconductor body (53), of a first material with electrical-insulator or dielectric characteristics; a first layer of metal material (58) extending in part on the first surface (53a) of the semiconductor body (53) and in part on the first insulating layer (61); an interface layer (63) on the first layer of metal material (58) and on the first insulating layer (61), of a second material different from the first material; and a passivation layer (69) of said first material on the interface layer (63). The first material is silicon oxide, and the second material is silicon nitride.

## Description

The present invention relates to an electronic device and to a method for manufacturing the electronic device. In particular, the electronic device is a SIC-based device and has enhanced robustness.

The semiconductor industry has been showing considerable interest in silicon carbide (SiC), in particular for the manufacture of electronic components such as diodes or transistor, above all for power applications.

The electronic devices formed in a silicon-carbide substrate, in its different polytypes (for example, 3C-SiC, 4H-SiC, 6H-SiC), have numerous advantages such as low on-state output resistance, low leakage current, resistance to high operating temperatures and high operating frequencies.

However, the development and manufacture of SiC-based electronic devices are limited by factors such as the electrical and mechanical properties of passivation layers (comprised in these electronic devices and, for example, extending over semiconductor bodies of SiC of the electronic devices). In particular, it is known to obtain the passivation layers by using polymeric materials (e.g., polyimide) that make it possible to withstand high operating temperatures of the electronic devices and present high dielectric strength, for example higher than 400 kV/mm. In detail, the high dielectric strength of the polymeric materials guarantees that the passivation layers withstand high electrical fields, and consequently high differences of potential across them, without undergoing electrical breakdown, and therefore without becoming electrically conductive.

However, polymeric materials have high coefficients of thermal expansion (CTE) (e.g., CTE = 43e⁻⁶ 1/K for the material polybenzobisoxazole, or PIX), and this causes problems of adhesion of the SiC passivation layer, which presents a lower coefficient of thermal expansion (CTE = 3.8e⁻⁶ 1/K).

In particular, these problems of adhesion between the passivation layer and the SiC may arise during thermal cycling tests (conducted, for example, between approximately -50°C and approximately +150°C) or during use of the electronic device, when the latter is subjected to high thermal swings (e.g., it is subjected to differences of operating temperature equal to, or higher than, approximately 200°C). On account of the large difference in CTE between the passivation layer and the SiC, these high thermal swings generate mechanical stresses at an interface between the passivation layer and the SiC, which can lead to (at least partial) delamination of the passivation layer with respect to the SiC semiconductor body.

In the case where this delamination were to be sufficiently extensive (e.g., such that no portion of the passivation layer is interposed between two metallizations of the electronic device set at different potentials, which are therefore separated from one another only by air), electrical discharges may be generated at said interface, leading to damage of the electronic device itself. In particular, the risk of damage of the electronic device increases when the latter is used in reverse-biasing conditions, on account of the high voltage difference (e.g., higher than 1000 V) to be withstood.

Known solutions to this problem comprise the use of a plurality of dielectric layers of materials different from one another (e.g., silicon nitride, silicon oxide and polyimide in succession to one another) to form a passivation multilayer designed to limit the mechanical stresses at the interface with the SiC semiconductor body.

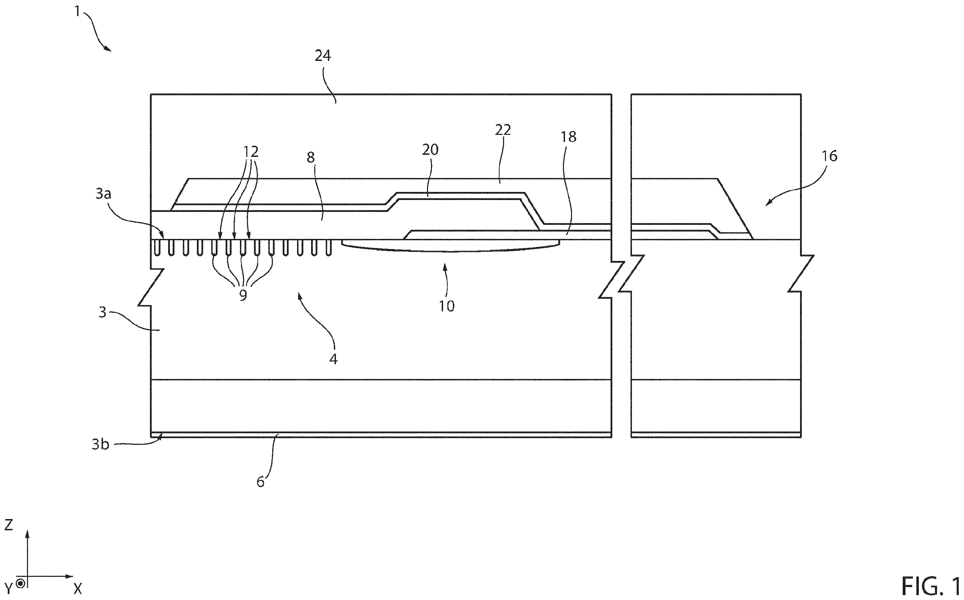

Figure 1 shows, in lateral cross-sectional view in a (triaxial) cartesian reference system of axes X, Y, Z, a portion of an electronic device (here by way of example a JBS or Junction barrier Schottky diode) 1 of a known type.

The JBS device 1 comprises a semiconductor body 3 of SiC of an N type, provided with a surface 3a opposite to a surface 3b. The semiconductor body includes, for example, a substrate and one or more regions grown epitaxially on the substrate, of an N type and having respective values of doping concentration. The JBS device 1 further comprises multiple junction barrier (JB) elements 9 in the semiconductor body 3, facing the top surface 3a and each including a respective implanted region in the semiconductor body 3, of a P type, and an ohmic contact on the implanted region, at the level of the top surface 3a of the semiconductor body 3. The JBS device 1 further comprises a first metallization 8, which extends over the top surface 3a, in electrical contact with the junction barrier elements 9 through the respective ohmic contacts. The JBS device 1 further comprises an edge-termination region 10 (or protection ring), in particular an implanted region of a P type, which surrounds completely the JB elements 9.

Schottky diodes 12 are formed at the interface between the anode metallization 8 and the semiconductor body 3, where semiconductor-metal Schottky junctions are formed. The region of the MPS device 1 that includes the JB elements 9 and the Schottky diodes 12 (namely, the region contained within the protection ring 10) is an active area 4 of the JBS device 1.

The JBS device 1 further comprises a second metallization 6, which extends over the bottom surface 3b. The first and the second metallizations 8, 6 form, respectively, electrical anode and cathode terminals, which can be biased during use of the JBS device 1.

Extending outside the edge-termination region 10 is an electrically passive region 16.

Extending partially over the edge-termination region 10 is an insulating layer 18, of insulating or dielectric material, in particular silicon oxide (SiO₂).

The first metallization 8 is in electrical contact with a portion of the edge-termination region 10, where the latter is not covered by the insulating layer 18, and likewise extends partially over the insulating layer 18. An interface layer 20, here of silicon nitride (SiN), extends over the first metallization 8 and the insulating layer 18. Furthermore, the JBS device 1 comprises a passivation layer 22, in particular of polyimide, which extends over the interface layer 20. In other words, the interface layer 20 serves as interface between the passivation layer 22 and the underlying layers, here the first metallization 8 and the insulating layer 18. The interface layer 20 may be omitted; however, the present applicant has found that the interface layer 20 improves adhesion of the passivation layer 22 with the underlying layers.

A protection layer 24 of a resin, such as bakelite, extends over the passivation layer 22, protecting the JBS device 1 when inserted in a package (not illustrated).

However, even though the interface layer 20 improves, as has been said, adhesion of the passivation layer 22 with the underlying layers, some critical conditions of use or testing of the JBS device 1 (e.g., thermo-mechanical or thermal stresses) may cause a delamination or partial detachment of the passivation layer 22 from the interface layer 20. This in particular occurs in conditions of stress caused by high temperatures of use (e.g., above 150°C). This effect, in addition to rendering the JBS device 1 structurally brittle, may be a contributing cause of the occurrence of undesired electrical discharges that affect electrical operation of the JBS device 1. In fact, the applicant has found that phenomena of mechanical stress, for example during assembly, may generate a stress in the interface layer 20 such as to cause local cracks thereof throughout the thickness, which, at the first metal layer 8, are the cause of these electrical discharges. These problems are all the more evident when the electronic device 1 is subjected to high thermal swings and to high voltage differences in reverse-biasing conditions.

Document WO 2021/065722 A1 describes a semiconductor device comprising: a chip; an electrode formed on the chip; an inorganic insulating layer of polyimide that covers the electrode.

Document JP 6224292 B2 relates to a semiconductor device, in particular to a power semiconductor device formed in a silicon substrate or a silicon carbide substrate; a polyimide layer is used as passivation layer.

The need is therefore felt to overcome the aforementioned problems.

According to the present invention, an electronic device and a method for manufacturing the electronic device are provided, as defined in the annexed claims.

For a better understanding of the present invention, a preferred embodiment thereof is now described, purely by way of non-limiting example, with reference to the attached drawings, wherein:
- Figure 1 illustrates, in a cross-sectional view, an electronic device of a known type;
- Figure 2 illustrates, in a cross-sectional view, an electronic device according to an embodiment of the present invention;
- Figures 3A-3D show, in cross-sectional views, steps for manufacturing the electronic device of Figure 2, according to an embodiment of the present invention and limitedly to steps useful for understanding the present invention; and
- Figure 4 illustrates, in a cross-sectional view, an electronic device according to a further embodiment of the present invention.

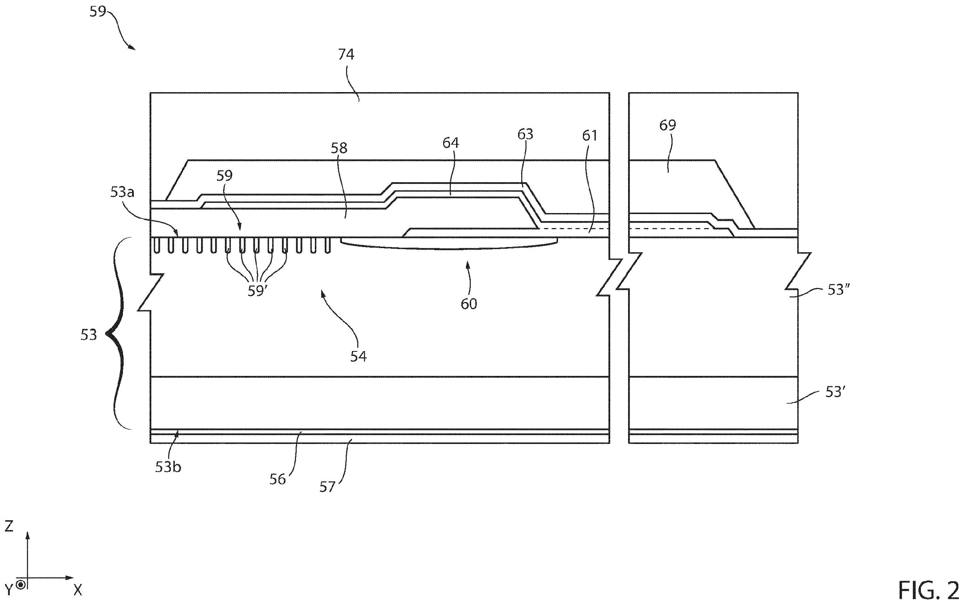

Figure 2 shows, in lateral cross-sectional view in the same (triaxial) cartesian reference system of axes X, Y, Z of Figure 1, an electronic device 50 according to an aspect of the present invention. In particular, the device 50 is a JBS diode, similar to what has been described with reference to Figure 1; however, the present invention is not limited to this device and finds application also in other types of electronic devices, in particular power devices, such as MOSFET, IGBT, MPS, Schottky diode, PN diode, PiN diode, etc.

The electronic device 50 comprises the elements described hereinafter, illustrated with reference to Figure 2.

A semiconductor body (i.e., including a substrate and, optionally, one or more epitaxial layers grown thereon) 53, of SiC with a doping of an N or a P type (in what follows a doping of an N type will be used as example), is provided with a surface 53a opposite to a surface 53b in the direction of the axis Z. The semiconductor body 53 includes, in this example, a substrate 53' on which a drift layer (epitaxial layer) 53" has been grown, consisting of SiC of an N type (in particular 4H-SiC, however, other polytypes may be used such as, but not exclusively, 2H-SiC, 3C-SiC and 6H-SiC). For instance, the substrate has a concentration of dopants of an N type comprised between 1·10¹⁹ at/cm³ and 1·10²² at/cm³ and has a thickness, measured along the axis Z between the surfaces 53a and 53b, comprised between 300 µm and 450 µm, and in particular equal to approximately 360 µm. The drift layer has a respective dopant concentration lower than the dopant concentration of the substrate and a thickness comprised, for example, between 5 and 15 µm.

An ohmic-contact layer 56 (for example, of nickel silicide) extends over the surface 53b of the substrate 53, and a metallization 57, in this example a cathode metallization, for example, of Ti/NiV/Ag or Ti/NiV/Au, extends over the ohmic-contact region 56.

One or more doped regions 59' of a P type extend in the semiconductor body 53 (in particular, in the drift layer), facing the top surface 53a; each doped region 59' houses a respective ohmic contact (not shown and of a known type) such that each doped region 59' forms a respective junction barrier (JB) element 59. An edge-termination region, or protection ring, 60, in particular a further doped region of a P type, extends in the drift layer, faces the top surface 53a, and surrounds completely (in plan view, in a plane XY defined by the axes X and Y) the JB elements 59. The edge-termination region 60 may be omitted.

An insulating layer 61 (of insulating or dielectric material, in particular of inorganic material such as, for example, Silicon Oxide or TEOS) extends over the top surface 53a so as to surround completely (in view in the plane XY) the JB elements 59 and to partially overlap the protection ring 60 (when present).

A metallization 58, in this example an anode metallization, for example, of Ti/AlSiCu or Ni/AlSiCu, extends over a portion of the top surface 53a delimited on the outside by the insulating layer 61 (i.e., at the JB elements 59/active area 54) and, partially, over the insulating layer 61.

One or more Schottky diodes 62 are formed at the interface between the semiconductor body 53 and the anode metallization 58, alongside the doped regions 59'. In particular, (semiconductor-metal) Schottky junctions are formed by portions of the semiconductor layer 53 in direct electrical contact with respective portions of the anode metallization 58.

Furthermore, each ohmic contact extending in the respective doped region 59' provides an electrical connection having a value of electrical resistivity lower than the value of electrical resistivity of the doped region 59' that houses it. The JB elements 59 are therefore PiN diodes.

The region of the electronic device 50 that includes the JB elements 59 and the Schottky diodes 62 (i.e., the region delimited by the protection ring 60) is an active area 54 of the electronic device 50.

Present outside the active area 54, i.e., beyond the edge-termination region 60, is a lateral surface 53c of the semiconductor body 53, for example extending substantially orthogonal to the top surface 53a. The lateral surface 53c is formed following upon a step of dicing or singulation of a SiC wafer in which a plurality of electronic devices 50 are obtained. The dicing step has the function of separating one electronic device 50 from another device 50 of the same wafer. Dicing takes place at a scribe line (not shown) of the SiC wafer from which the electronic device 50 is obtained; this scribe line surrounds at a distance, in the plane XY, the active region 54, the protection ring 60, and the insulating layer 61.

A protection layer 74, of a resin, such as, for example, bakelite, extends over the passivation layer 69, protecting the electronic device 50 when inserted in a package (not illustrated).

A further insulating layer 64, in particular of a dielectric or insulating material (for example, the same material as the one used for the insulating layer 61, such as silicon oxide or TEOS) extends over the anode metallization 58 and the insulating layer 61, where the latter is exposed alongside the anode metallization 58.

The insulating layer 61 has, for example, a thickness, along the axis Z, comprised between 0.5 and 2 µm; the insulating layer 64 has, for example, a thickness, along the axis Z, comprised between 0.5 and 2 µm.

An interface layer 63, here of silicon nitride (SiN), extends over the insulating layer 64.

A passivation layer 69 extends on the interface layer 63. The interface layer 63 serves as interface between the passivation layer 69 and the underlying layers, here the insulating layer 64.

According to an aspect of the present invention, the passivation layer 69 is of insulating or dielectric material, in particular the same material as that of the insulating layer 64. In this way, any possible thermal stresses to which the device 50 is subjected during use or during testing steps do not have a significant impact, in terms of stress, on the interface layer 63, which is therefore less subject to cracking. The passivation layer 69 is, for example, of silicon oxide or TEOS.

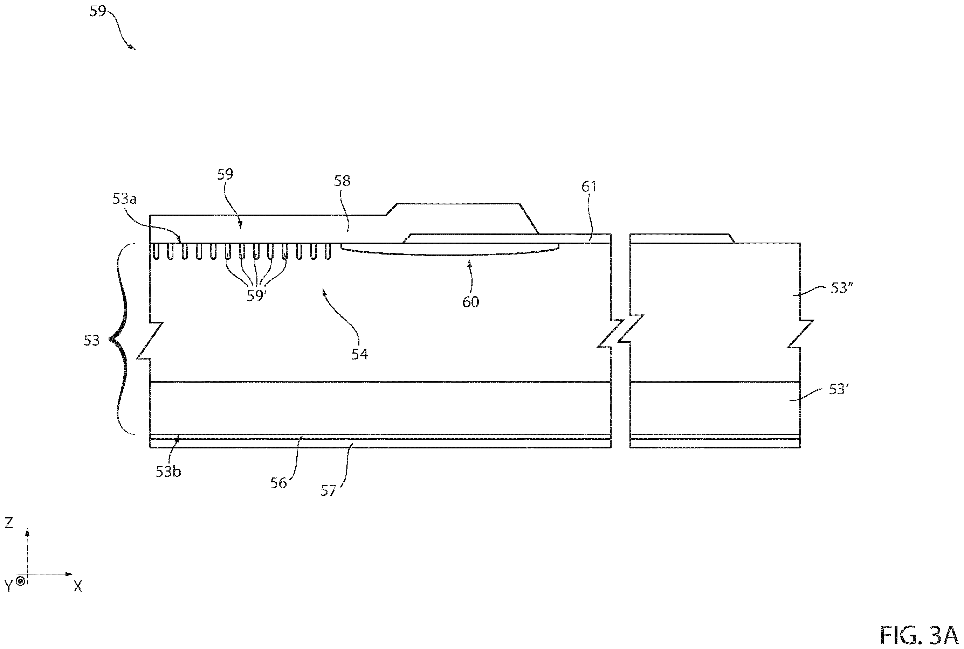

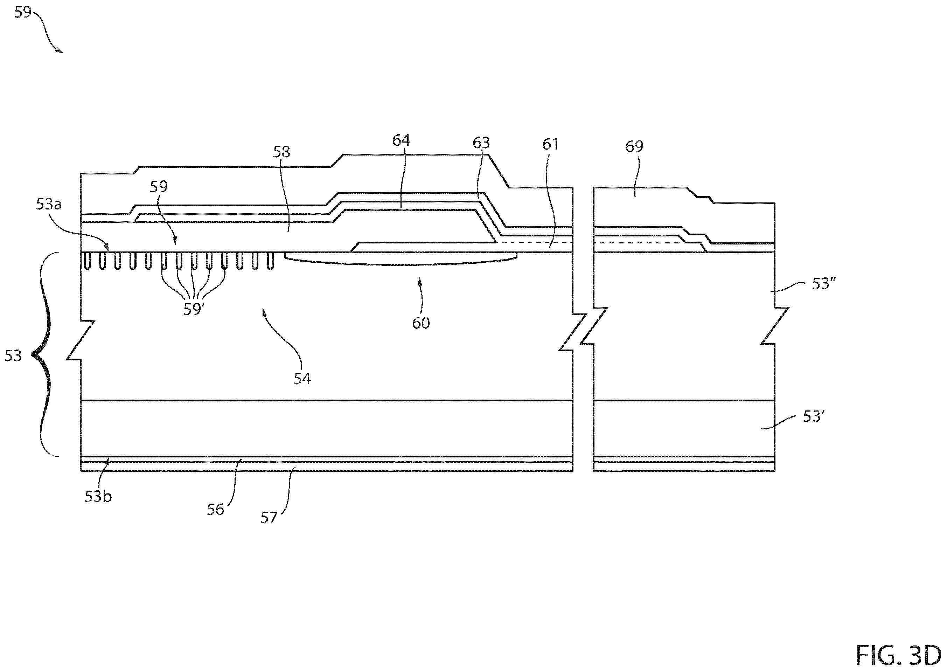

Steps for manufacture of the electronic device 50 of Figure 2 are described in what follows with reference to Figures 3A-3D and limitedly to manufacturing steps useful for understanding the present invention. Figures 3A-3D are represented in the same triaxial system as that of Figure 2.

With reference to Figure 3A, a wafer is provided that includes the SiC semiconductor body 53, following upon manufacturing steps that are designed to form elements of the electronic device 50 described previously (and not discussed here any further) and identified by the same reference numbers.

With reference to Figure 3A, after formation of the insulating layer 61 and of the anode metallization 58, a step is carried out of deposition of insulating or dielectric material to form the insulating layer 64. This step is carried out, for example, by a CVD or LPCVD process. The insulating layer 64 is formed on the entire surface of the wafer and in particular completely covers the anode metallization 58 and the insulating layer 61.

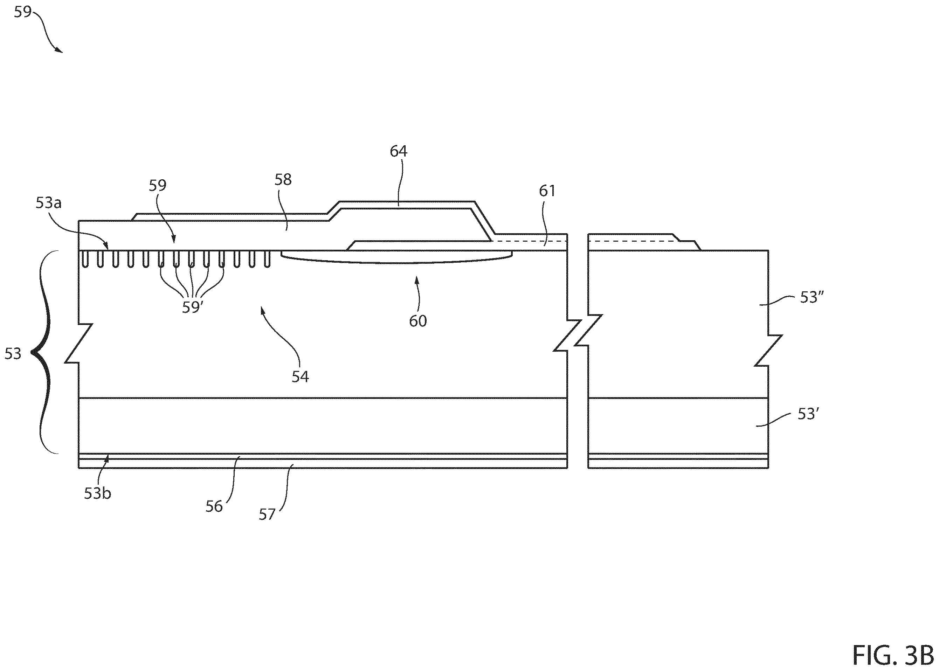

Then, Figure 3B, after formation of the insulating layer 64, the interface layer 63 is formed, for example, by deposition of a CVD type of silicon nitride. The interface layer 63 is formed on the entire surface of the wafer and in particular covers completely the insulating layer 64.

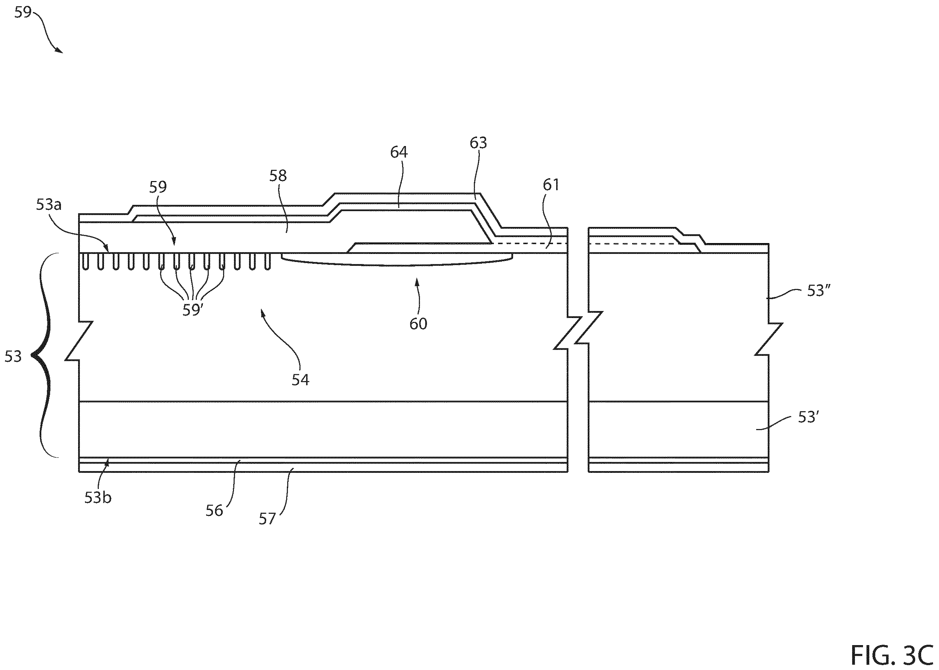

Then, Figure 3C, the passivation layer 69 is formed. This step envisages deposition of insulating material, for example silicon oxide or TEOS deposited using the CVD or LPCVD technique. The passivation layer 69 has a thickness chosen, for example, in the range between 1 and 10 µm.

The passivation layer 69 covers the interface layer 63 completely and can be patterned (for example, by lithographic and etching steps) according to the need.

The manufacturing process then continues with subsequent steps to form the further elements of the electronic device 50, not described in detail here (for example, the ohmic-contact layer 56 and the cathode metallization 57).

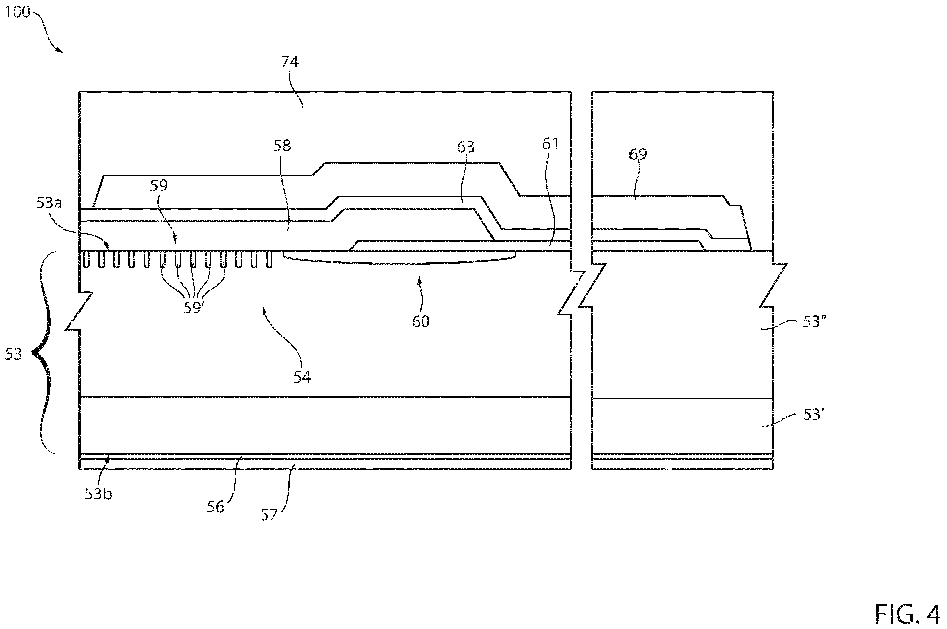

Figure 4 illustrates an electronic device 100 according to a further embodiment of the present invention. The electronic device 100 is represented in the same (triaxial) cartesian reference system of axes X, Y, Z as those of Figures 1 and 2. In particular, the electronic device 100 is a JBS diode, similar to what has been described with reference to Figures 1 and 2; however, also in this case, the present invention is not limited to a JBS device and finds application also in other types of electronic devices, in particular power devices, such as MOSFET, IGBT, MPS, Schottky diode, PN diode, PiN diode, etc.

Elements of the electronic device 100 common to the electronic device 50 of Figure 2 are designated by the same reference numbers and will not be described any further.

In particular, the electronic device 100 does not comprise the insulating layer 64. Therefore, in this embodiment, the interface layer 63 extends directly on, and in contact with, the anode metallization 58 and with the insulating layer 61.

The passivation layer 69, of the type already described previously, extends over the interface layer 63 and is physically separated from the anode metallization 58 and from the insulating layer 61 by the interface layer 63. The steps for manufacturing the electronic device 100 are similar to those described with reference to Figures 3A-3D, with the exception of the step regarding formation of the insulating layer 64.

From an examination of the characteristics of the present disclosure according to the present invention the advantages that it allows to obtain are evident.

In particular, the passivation layer obtained according to the present invention is particularly robust and reliable during testing of thermal stresses of the electronic device. Furthermore, it reduces propagation of stresses that cause cracking of the interface layer 63.

In other words, the present invention (which avoids the need to provide the passivation layer 69 of polymeric material), guarantees high electrical performance of the electronic device 50, 100 and, at the same time, eliminates structural problems linked to the possible detachment of the polymeric passivation layer (e.g., following upon thermal cycles or cycles of use of the electronic device 50, 100).

Finally, it is clear that modifications and variations may be made to the present invention described and illustrated herein, without thereby departing from the scope of the present invention, as defined in the attached claims.

## Claims

1. An electronic device (50; 100), comprising:
a semiconductor body (53) of silicon carbide;
a first insulating layer (61) on a first surface (53a) of the semiconductor body (53), of a first material with electrical-insulator or dielectric characteristics;
a first layer of metal material (58) extending in part on the first surface (53a) of the semiconductor body (53) and in part on the first insulating layer (61);
an interface layer (63) on the first layer of metal material (58) and on the first insulating layer (61), of a second material different from the first material; and
a passivation layer (69) of said first material above the interface layer (63).

2. The electronic device according to claim 1, wherein the first material is an inorganic material, in particular Silicon Oxide or TEOS.

3. The electronic device according to claim 1 or 2, wherein the second material is Silicon Nitride.

4. The electronic device according to any one of the preceding claims, further comprising a second insulating layer (64) interposed between the interface layer (63) and the underlying first insulating layer (61) and first layer of metal material (58).

5. The electronic device according to claim 4, wherein the second insulating layer (64) is of said first material.

6. The electronic device according to any one of the preceding claims, further comprising an active area (54), said first layer of metal material (58) extending at least in part overlapping, and in electrical contact with, the first surface (53a) of the semiconductor body at the active area (54).

7. The electronic device according to claim 6, further comprising an edge-termination region (60) surrounding, at least in part, the active area (54),
wherein the edge-termination region (60) is a region implanted in the semiconductor body at the first surface (53a) and has an electrical conductivity opposite to that of the semiconductor body (53),
the first insulating layer (61) extending on the first surface (53a) at a distance from the active area (54) and at least partially overlapping the edge-termination region (60) .

8. The electronic device according to claim 6 or 7, further comprising a second layer of metal material (57) on a second surface (53b), opposite to the first surface (53a), of the semiconductor body (53), wherein the first layer of metal material (58) and the second layer of metal material (57) form respective electrical-conduction terminals of the electronic device (50; 100).

9. The electronic device according to any one of claims 6-8, further comprising one or more junction barrier diodes (59) and/or Schottky diodes in said active area (54), at the first surface (53a).

10. The electronic device according to any one of the preceding claims, chosen in the group comprising: a Schottky diode, a PiN diode, a PN diode, an MPS device, a JBS diode, a MOSFET, an IGBT, a power device.

11. A method for manufacturing an electronic device (50; 100), comprising the steps of:
forming, on a first surface (53a) of a semiconductor body (53) of silicon carbide, a first insulating layer (61) of a first material with electrical-insulator or dielectric characteristics;
forming a first layer of metal material (58) in part on the first surface (53a) of the semiconductor body (53) and in part on the first insulating layer (61);
forming an interface layer (63) on the first layer of metal material (58) and on the first insulating layer (61), of a second material different from the first material; and
forming a passivation layer (69) of said first material above the interface layer (63).

12. The manufacturing method according to claim 11, wherein the first material is an inorganic material, in particular Silicon Oxide or TEOS.

13. The manufacturing method according to claim 11 or 12, wherein the second material is Silicon Nitride.

14. The manufacturing method according to any one of claims 11 to 13, further comprising the step of forming a second insulating layer (64) on the first insulating layer (61) and on the first layer of metal material (58), and wherein the step of forming the interface layer (63) comprises forming the interface layer (63) on the second insulating layer (64).

15. The manufacturing method according to claim 14, wherein the second insulating layer (64) is of said first material.

16. The manufacturing method according to any one of claims 11 to 15, further comprising the step of forming an active area (54), said first layer of metal material (58) being formed at least in part overlapping, and in electrical contact with, the first surface (53a) of the semiconductor body at the active area (54).

17. The manufacturing method according to claim 16, further comprising the step of implanting, in the semiconductor body at the first surface (53a) and surrounding at least in part the active area (54), dopant species having an electrical conductivity opposite to that of the semiconductor body (53), thus forming an edge-termination region (60),
the first insulating layer (61) being formed on the first surface (53a) at a distance from the active area (54) and at least partially overlapping the edge-termination region (60).

18. The manufacturing method according to claim 16 or claim 17, further comprising the step of forming a second layer of metal material (57) at a second surface (53b), opposite to the first surface (53a), of the semiconductor body (53), wherein the first layer of metal material (58) and the second layer of metal material (57) form respective electrical-conduction terminals of the electronic device (50; 100).

19. The manufacturing method according to any one of claims 16 to 18, further comprising the step of forming one or more junction barrier diodes (59) and/or Schottky diodes in said active area (54), at the first surface (53a).

20. The manufacturing method according to any one of claims 11 to 19, wherein said electronic device is chosen in the group comprising: a Schottky diode, a PiN diode, a PN diode, an MPS device, a JBS diode, a MOSFET, an IGBT, a power device.
